# EUROPÄISCHE PATENTANMELDUNG

(11) **EP 1 818 425 A1**
(43) Veröffentlichungstag der Anmeldung: **15.08.2007**
(21) Anmeldenummer: 06002358.7
(22) Anmeldetag: 06.02.2006
(51) Int. Cl.: C23C 14/04

(54) **Verfahren zur Herstellung von partiell metallisierten Trägersubstraten**

(30) Priorität: 06.02.2006 EP 06002358
(71) Anmelder: Hueck Folien Ges.m.b.H., 4342 Baumgartenberg (AT)
(72) Erfinder: Treutlein, Roland, 92712 Pirk (DE); Hilburger, Johann, 92712 Pirk (DE)
(74) Vertreter: Landgraf, Elvira

(57) **Zusammenfassung**

Verfahren zur Herstellung eines partiell metallisierten Trägersubstrats, gekennzeichnet durch folgende Verfahrensschritte:
a) Bereitstellen eines ersten Trägersubstrats
b) partielles Bedrucken oder Beschichten des Trägersubstrats mit einem auf dem Trägersubstrat nur schwach haftenden Lack
c) Aufbringen einer vollflächigen metallischen Schicht
d) Kaschieren gegen ein klebebeschichtetes zweites Trägersubstrat und
e) Ablösen dieses zweiten klebebeschichteten Trägersubstrats, wodurch der schwach haftende Lack mit der darüberliegenden metallischen Schicht vom ersten Trägersubstrat abgelöst wird und so eine strukturierte metallische Schicht auf dem ersten Trägersubstrat zurückbleibt.

## Beschreibung

Die Erfindung betrifft ein Verfahren zur Herstellung von partiell metallisierten Trägersubstraten.
Partiell metallisierte Trägersubstrate werden beispielsweise in der Elektronikindustrie als Leiterbahnen, Antennen, RF-Antennen, leitfähige Kontakte, Anschlussflächen für gedruckte Elektronik oder Kontakt-Pins für ICs verwendet.
Ferner ist es bekannt metallisierte bzw. partiell metallisierte Trägersubstrate als Sicherheitselemente in unterschiedlichen Formaten (Streifen, Fäden, Patches etc) in oder auf Datenträgern, Wertdokumenten, beispielsweise Banknoten, Ausweisen und dergleichen, in oder auf Verpackungen und dergleichen zu verwenden.

Aus der WO 99/13157 A1 sind Sicherheitsfolien für Wertpapiere bekannt, bei denen auf einer transluzenten Folie eine metallische Beschichtung aufgebracht wird, die in der fertigen Folie nicht vollflächig ist, sondern Aussparungen aufweist, die im Durchlicht klar erkennbar sein sollen. Die Herstellung dieser Folien erfolgt dadurch, dass eine Trägerfolie mit einer hochpigmentierten Druckfarbe bedruckt wird, wobei der Farbauftrag nicht vollflächig erfolgt, die Druckfarbe unter Bildung eines porigen Farbauftrags getrocknet wird, anschließend eine metallische Deckschicht aufgebracht wird und in einem weiteren Schritt die hochpigmentierte Druckfarbe durch Auswaschen mit einem Lösungsmittel, gegebenenfalls auch unter mechanischer Einwirkung entfernt wird. Damit wird auch in jenen Bereichen, in denen die Druckfarbe entfernt wird, die metallische Abdeckschicht mitentfernt, wodurch die im Durchlicht erkennbaren Aussparungen gebildet werden. Die metallische Abdeckschicht weist eine Dicke von 0,01 bis 1 µm auf.

Aus der WO 02/31214 A1 ist eine partiell metallisierte Folie und ein Verfahren zu deren Herstellung bekannt wobei auf ein Substrat oder eine Trägerfolie entweder mit einer löslichen Farbe eine Struktur gedruckt wird, und/oder die Grundmaterialien direkt im Vakuum mittels einer Plasmabehandlung gereinigt und gleichzeitig mit Targetatomen bekeimt werden, worauf ein Metall aufgedampft und anschließend die strukturierte Schicht durch Auswaschen der löslichen Farbe oder durch Ätzen erzeugt wird.

Insbesondere bei Verwendung eines Waschverfahrens zur Entfernung der partiell aufgebrachten löslichen Waschfarbe mit der darüber abgeschiedenen Metallschicht, ist meist eine mechanische Unterstützung des Waschvorgangs nötig. Dadurch wird allerdings auch oft die auf dem Substrat verbleibende Metallschicht zerkratzt.

Ferner sind beide Verfahren relativ aufwändig, beinhalten zahlreiche Verfahrensschritte. Daher können im Allgemeinen keine hohen Produktionsgeschwindigkeiten erreicht werden.

Aufgabe der Erfindung war es, ein Verfahren zur Herstellung eines partiell metallisierten Trägersubstrats bereitzustellen, das hohe Produktionsgeschwindigkeiten bei gleichzeitig ausreichender Präzision und in hoher Qualität erlaubt.

Gegenstand der Erfindung ist daher ein Verfahren zur Herstellung eines partiell metallisierten Trägersubstrats, gekennzeichnet durch folgende Verfahrensschritte:
a) Bereitstellen eines ersten Trägersubstrats
b) partielles Bedrucken oder Beschichten des Trägersubstrats mit einem auf dem Trägersubstrat nur schwach haftenden Lack
c) Aufbringen einer vollflächigen metallischen Schicht
d) Kaschieren gegen ein klebebeschichtetes zweites Trägersubstrat und
e) Ablösen dieses zweiten klebebeschichteten Trägersubstrats,
wodurch der schwach haftende Lack mit der darüberliegenden metallischen Schicht vom ersten Trägersubstrat abgelöst wird und so eine strukturierte metallische Schicht auf dem ersten Trägersubstrat zurückbleibt.

Als Trägersubstrat kommen beispielsweise Trägerfolien, vorzugsweise flexible Kunststofffolien, beispielsweise aus PI, PP, OPP, PE, PPS, PEEK, PEK, PEI, PSU, PAEK, LCP, PEN, PBT, PET, PA, PC, COC, POM, ABS, PVC Fluorpolymere wie Teflon und dergleichen in Frage. Die Trägerfolien weisen vorzugsweise eine Dicke von 5 - 700 µm, bevorzugt 5 - 200 µm, besonders bevorzugt 36 - 75 µm auf.

Ferner können als Trägersubstrat auch Metallfolien, beispielsweise Al-, Cu-, Sn-, Ni-, Fe- oder Edelstahlfolien mit einer Dicke von 5 - 200 µm, vorzugsweise 10 bis 80 µm, besonders bevorzugt 10 - 40 µm dienen. Die Folien können auch oberflächenbehandelt, beschichtet oder kaschiert beispielsweise mit Kunststoffen oder lackiert sein.

Ferner können als Trägersubstrate auch Papier oder Verbunde mit Papier, beispielsweise Verbunde mit Kunststoffen mit einem Flächengewicht von 20 - 500 g/m², vorzugsweise 40 - 200 g/m² verwendet werden.

Ferner können als Trägersubstrate Vliese, wie Endlosfaservliese, Stapelfaservliese und dergleichen, die gegebenenfalls vernadelt oder kalandriert sein können, verwendet werden. Vorzugsweise bestehen solche Vliese aus Kunststoffen, wie PP, PET, PA, PPS und dergleichen, es können aber auch Vliese aus natürlichen, gegebenenfalls behandelten Fasern, wie Viskosefaservliese eingesetzt werden. Die eingesetzten Vliese weisen ein Flächengewicht von etwa 20 g/m² bis 500 g/m² auf.

Anschließend wird ein schwach haftender Lack oder eine schwach haftende Beschichtung partiell auf dieses erste Trägersubstrat aufgebracht. Der Lack kann dabei in Form von Linien, Mustern, Bahnen, Symbolen, Zeichen und dergleichen aufgebracht werden.
Dabei wird der Lack in jenen Bereichen aufgebracht, in denen im fertigen Produkt metallfreie Bereiche vorliegen sollen.

In einer besonderen Ausführungsform kann die auf dem zweiten Trägersubstrat nach dem Abziehen vorhandene Struktur das fertige Produkt darstellen. Dadurch können auch beispielsweise Leiterbahnen auf Materialien wie Polypropylen hergestellt werden, die bei Direktbedampfung zu wenig temperaturstabil sind.

Die Aufbringung des auf dem Trägersubstrat schwach haftenden Lacks kann durch ein beliebiges Verfahren, beispielsweise durch Tiefdruck, Flexodruck, Siebdruck, Digitaldruck und dergleichen erfolgen.

Als schlecht haftende Lackschichten kommen insbesondere beispielsweise Lacke oder Beschichtungen auf Methacrylatbasis, auf Basis von Polyamid-, Polyethylen-, Fluorpolymerwachs, Silikon-, Stärke- oder dünne Ölschichten in Frage.

Anschließend wird die metallische Schicht aufgebracht. Diese Schicht besteht aus einem Metall, einer Metallverbindung, oder einer Legierung. Als Metallschicht sind Schichten aus Al, Cu, Fe, Ag, Au, Cr, Ni, Zn und dergleichen geeignet. Als Metallverbindungen sind beispielsweise Oxide oder Sulfide von Metallen, insbesondere TiO₂, Cr-Oxide, ZnS, ITO, ATO, FTO, ZnO, Al₂O₃ oder Siliciumoxide geeignet. Geeignete Legierungen sind beispielsweise Cu-Al Legierungen, Cu-Zn Legierungen und dergleichen.
Vorzugsweise besteht die metallische Schicht aus Kupfer, Aluminium, Silber oder Gold.

Diese metallische Schicht kann durch bekannte Verfahren, beispielsweise durch Bedampfen, Sputtern, Drucken (Tief-, Flexo-, Sieb-, Digitaldruck und dergleichen), Sprühen, Galvanisieren und dergleichen aufgebracht werden. Die Dicke der funktionellen Schicht beträgt 0,001 bis 50 µm, vorzugsweise 0,1 bis 20 µm.

Zur eindeutigen Identifikation einer bestimmten Produktionscharge oder eines einzelnen Bestandteils oder Abschnitts einer Produktionscharge des erfindungsgemäß hergestellten metallisierten Trägersubstrats kann in einer besonderen Ausführungsform der schwach haftende Lack oder die schwach haftende Beschichtung mittels eines Digitaldruckverfahrens individualisiert aufgebracht werden. Dabei wird der schwach haftende Lack bzw. die schwach haftende Beschichtung gegebenenfalls zusätzlich zu den im vorangehenden beschriebenen funktionellen Strukturen derart aufgebracht, dass er die Kontur des gewünschten individualisierten Codes umschließt.

Anschließend wird der so hergestellte Aufbau auf übliche Weise gegen ein mit einer Klebebeschichtung versehenes Trägersubstrat kaschiert. Vorzugsweise ist das Trägersubstrat mit einer Selbstklebebeschichtung versehen
Als Trägersubstrat kommt vorzugsweise eine flexible Kunststofffolie in Frage, beispielsweise aus PP, OPP, PE, PEI, PEN, PBT, PET, PA, PC, COC, POM, ABS, PVC und dergleichen.

Ferner können als Trägersubstrat auch Metallfolien, beispielsweise Al-, Cu-, Sn-, Ni-, Fe- oder Edelstahlfolien mit einer Dicke von 5 - 200 µm, vorzugsweise 10 bis 80 µm, besonders bevorzugt 10 - 40 µm dienen. Die Folien können auch oberflächenbehandelt, beschichtet oder kaschiert beispielsweise mit Kunststoffen oder lackiert sein.

Ferner können als Trägersubstrate auch Papier oder Verbunde mit Papier, beispielsweise Verbunde mit Kunststoffen mit einem Flächengewicht von 20 - 500 g/m², vorzugsweise 40 - 200 g/m² verwendet werden.

Ferner können als Trägersubstrate Vliese, wie Endlosfaservliese, Stapelfaservliese und dergleichen, die gegebenenfalls vernadelt oder kalandriert sein können, verwendet werden. Vorzugsweise bestehen solche Vliese aus Kunststoffen, wie PP, PET, PA, PPS und dergleichen, es können aber auch Vliese aus natürlichen, gegebenenfalls behandelten Fasern, wie Viskosefaservliese eingesetzt werden. Die eingesetzten Vliese weisen ein Flächengewicht von etwa 20 g/m² bis 500 g/m² auf. Ferner können auch Verbunde mit Vliesen und dergleichen eingesetzt werden.

Anschließend wird dieses Trägersubstrat vom mit der metallischen Beschichtung versehenen Trägersubstrat abgezogen.

Dadurch löst sich der schlecht haftende Lack mit der darüberliegenden metallischen Beschichtung vom ersten Trägersubstrat, auf dem Trägersubstrat bleiben metallische funktionelle Strukturen zurück. Ebenso bleiben gegebenenfalls die metallischen Strukturen, die den individualisierten Code bilden auf dem Trägersubstrat zurück

Das erfindungsgemäße Verfahren ist einfach und wirtschaftlich mit wenigen Verfahrensschritten durchführbar.
Da keine Wasch- oder Ätzlösung zur Herstellung der partiell metallisierten Strukturen verwendet wird, ist das Verfahren gegenüber den aus dem Stand der Technik bekannten Verfahren umweltschonender und kostengünstiger

Das durch das erfindungsgemäße Verfahren hergestellte partiell metallisierte Trägersubstrat kann für elektronische Bauteile, beispielsweise für Leiterbahnen, Antennen, RF-Antennen, leitfähige Kontakte, Anschlussflächen für gedruckte Elektronik oder Kontakt-Pins für ICs gegebenenfalls mit einem individualisierten Code und dergleichen verwendet werden.
Ferner kann das nach dem erfindungsgemäßen Verfahren hergestellte Trägersubstrat als Sicherheitselement in oder auf Datenträgern, wie Eintrittskarten, Gewinnkupons, Behälterabdeckungen mit Gewinnabschnitten und dergleichen, auf oder in Wertdokumenten, wie Banknoten, Ausweisen, in oder auf Verpackungen verwendet werden.

### Beispiel:

Auf eine 50 µm dicke PEN Folie wird in einem Tiefdruckverfahren partiell ein Lack auf Methacrylatbasis aufgebracht.
Anschließend wird eine vollflächige metallische Schicht aus Kupfer (0,5 µm) in einem PVD-Verfahren aufgebracht.
Der so hergestellte Aufbau wird gegen eine mit einer konventionellen Selbstklebebeschichtung versehene PET-Folie kaschiert und anschließend wieder getrennt.
Durch den Trennvorgang löst sich die Lackschicht mit der darüberliegenden Beschichtung, es wird die metallische Struktur auf dem ersten Trägersubstrat sichtbar.

## Patentansprüche

1. Verfahren zur Herstellung eines partiell metallisierten Trägersubstrats, **gekennzeichnet durch** folgende Verfahrensschritte:
a) Bereitstellen eines ersten Trägersubstrats
b) partielles Bedrucken oder Beschichten des Trägersubstrats mit einem auf dem Trägersubstrat nur schwach haftenden Lack
c) Aufbringen einer vollflächigen metallischen Schicht
d) Kaschieren gegen ein klebebeschichtetes zweites Trägersubstrat und
e) Ablösen dieses zweiten klebebeschichteten Trägersubstrats,
wodurch der schwach haftende Lack mit der darüberliegenden metallischen Schicht vom ersten Trägersubstrat abgelöst wird und so eine strukturierte metallische Schicht auf dem ersten Trägersubstrat zurückbleibt.

2. Verfahren nach Anspruch 1, **dadurch gekennzeichnet, dass** das in Schritt d) verwendete Trägersubstrat mit einer Selbstklebebeschichtung versehen ist.

3. Verfahren nach einem der Ansprüche 1 oder 2 , **dadurch gekennzeichnet, dass** als schwach haftender Lack oder schwach haftende Beschichtung ein Lack auf Basis von Methacrylat, auf Basis von Polyamid-, Polyethylen-, Fluorpolymerwachs, Silikon- , Stärke- oder dünne Ölschichten aufgebracht wird.

4. Verfahren nach einem der Ansprüche 1 oder 2, **dadurch gekennzeichnet, dass** als vollflächige metallische Schicht eine Schicht aus Al, Cu, Fe, Ag, Au, Cr, Ni, Zn, aus Oxiden oder Sulfiden von Metallen, insbesondere TiO₂, Cr-Oxiden, ZnS, ITO, ATO, FTO, ZnO, Al₂O₃ oder Siliciumoxiden aufgebracht wird.

5. Verfahren nach einem der Ansprüche 1 bis 3, **dadurch gekennzeichnet, dass** das als erstes Trägersubstrat eine flexible Kunststofffolie aus PI, PP, OPP, PE, PPS, PEEK, PEK, PEI, PSU, PAEK, LCP, PEN, PBT, PET, PA, PC, COC, POM, ABS, PVC, Fluorpolymeren wie PTFE oder ETFE, verwendet wird.

6. Verfahren nach einem der Ansprüche 1 bis 5, **dadurch gekennzeichnet, dass** das zweite Trägersubstrat eine flexible Folie aus PP, OPP, PE, PEI, PEN, PBT, PET, PA, PC, COC, POM, ABS, PVC ist.

7. Verfahren nach einem der Ansprüche 1 bis 6, **dadurch gekennzeichnet, dass** die metallische Struktur, die auf das zweite Trägersubstrat transferiert wurde das fertige Produkt darstellt.

8. Verwendung des nach einem der Ansprüche 1 bis 7 hergestellten Trägersubstrats für elektronische Bauteile, Leiterbahnen, Antennen, RF-Antennen, leitfähige Kontakte, Anschlussflächen für gedruckte Elektronik oder Kontakt-Pins für ICs.

9. Verwendung des nach einem der Ansprüche 1 bis 7 hergestellten Trägersubstrats für elektronische Bauteile, Leiterbahnen, Antennen, RF-Antennen, leitfähige Kontakte, Anschlussflächen für gedruckte Elektronik oder Kontakt-Pins für ICs, die mit einem individualisierten Code versehen sind.

10. Verwendung des nach einem der Ansprüche 1 bis 7 hergestellten Trägersubstrats als Sicherheitselemente in oder auf Datenträgern, Wertdokumenten oder Verpackungen, die gegebenenfalls mit einem individualisierten Code versehen sind.
